# EUROPEAN PATENT APPLICATION

(11) **EP 3 885 415 A1**
(43) Date of publication of application: **29.09.2021**
(21) Application number: 19911491.9
(22) Date of filing: 27.12.2019
(51) Int. Cl.: C09D 17/00, H01B 1/00, H01B 1/22, H01B 5/14, H01B 13/00, H05K 1/09, H05K 3/12

(54) **ELECTROCONDUCTIVE PASTE, SUBSTRATE EQUIPPED WITH ELECTROCONDUCTIVE FILM, AND METHOD FOR MANUFACTURING SUBSTRATE EQUIPPED WITH ELECTROCONDUCTIVE FILM**

(30) Priority: 23.01.2019 JP 2019009437
(71) Applicant: Taiyo Nippon Sanso Corporation, Tokyo 142-8558 (JP)
(72) Inventor: MIYOSHI, Kentaro, Tokyo 142-8558 (JP); HOSOKAWA, Ryuhei, Tokyo 142-8558 (JP); IGARASHI, Hiroshi, Tokyo 142-8558 (JP)
(74) Representative: HGF
(86) International application number: PCT/JP2019/051355
(87) International publication number: WO 2020/153101

(57) **Abstract**

One object of the present invention is to provide an electroconductive paste capable of forming an electroconductive film on a substrate having low heat resistance by light irradiation, having unlimited sintering conditions, excellent adhesion to a resin substrate, and capable of forming an electroconductive film having good electroconductivity, and the present invention provides an electroconductive paste wherein the electroconductive paste contains fine copper particles having an average particle diameter of 300 nm or less which is measured using SEM, coarse copper particles having an average particle diameter of 3 ∼ 11 µm which is measured using SEM, a binder resin, and a dispersion medium, the fine copper particles includes a coating film containing cuprous oxide and copper carbonate on at least a part of the surface thereof, the ratio of the mass oxygen concentration to the specific surface area of the fine copper particles is 0.1 ∼ 1.2 % by mass·g/m², the ratio of the mass carbon concentration to the specific surface area of the fine copper particles is controlled to 0.008 ∼ 0.3 % by mass·g/m², and the amount of the binder resin is 2.5 ∼ 6 parts by mass with respect to the total of 100 parts by mass of the fine copper particles and the coarse copper particles.

## Description

### TECHNICAL FIELD

The present invention relates to an electroconductive paste, a substrate equipped with an electroconductive film, and a method for manufacturing a substrate equipped with an electroconductive film.

### BACKGROUND ART

Materials for pattern formation such as wirings and circuits are known (for example, Patent Document 1). Patent Document 1 discloses a photosensitive paste. In the examples of Patent Document 1, a photosensitive paste is coated on a soda glass substrate, exposed to light, developed using a developing solution, sintered, and patterned.

An electroconductive paste containing copper particles has been proposed as a material for providing an electroconductive film on a substrate (for example, Patent Documents 2 to 4).

Patent Document 2 discloses that a copper ink containing copper nanoparticles is inkjet printed on a flexible substrate, the copper ink is photo-sintered using a pulse laser, and the copper nanoparticles are fused to form an electroconductive film.

Patent Document 3 discloses fine granular copper powder for a filler of a conductive ink. Patent Document 3 discloses that benzotriazole is adhered to the surface of the copper particles dispersed in fine granular copper powder as an oxidation resistant treatment.

Patent Document 4 discloses a coating material for forming an electroconductive film. The coating material for forming an electroconductive film contains fine copper powder A having an average particle diameter of primary particles of 10 to 100 nm, coarse copper powder B having a cumulative 50% particle diameter D₅₀ of 0.3 to 20.0 µm, copper oxide powder C having D50 of 0.1 to 10.0 µm, and resin D. The fine copper powder A has a coating layer of an azole compound on the surface thereof.

### PRIOR ART DOCUMENTS

### PATENT DOCUMENTS

Patent Document 1 Japanese Unexamined Patent Application, First Publication No. Hei 9-218508
Patent Document 2 Published Japanese Translation No. 2010-528428 of the PCT International Publication
Patent Document 3 Japanese Unexamined Patent Application, First Publication No. 2008-285761
Patent Document 4 Japanese Unexamined Patent Application, First Publication No. 2017-66269

### SUMMARY OF INVENTION

### PROBLEM TO BE SOLVED BY THE INVENTION

However, the photosensitive paste disclosed in Patent Document 1 needs to be sintered at a high temperature of 520 to 610°C during pattern processing. Therefore, it is impossible to perform pattern processing on a substrate having low heat resistance such as a paper substrate or a polyethylene terephthalate (PET) film. In addition, pattern processing cannot be performed by light irradiation.

In Patent Documents 2 to 4, when a resin substrate such as a polyethylene terephthalate film is used, there is no study on improving the adhesion between the substrate and the electroconductive film, and the adhesion between the resin substrate and the electroconductive film is not sufficient.

In the electroconductive paste proposed in Patent Documents 3 and 4, the copper particles are denatured by the azole compound, the viscosity of the electroconductive paste may increase, and the stability may decrease. Further, in order to improve the sinterability, it is essential to irradiate light having a specific wavelength. Therefore, the manufacturing conditions in photo-sintering are limited, and the industrial versatility is not sufficient.

In addition, when the electroconductive paste proposed in Patent Document 3 is coated on a substrate, dried, and the copper particles are sintered by light irradiation to form an electroconductive film, the electroconductive film may be cracked. Therefore, in the electroconductive film obtained using the electroconductive paste of Patent Document 3, the electroconductivity may decrease.

The object of the present invention is to provide an electroconductive paste capable of forming an electroconductive film on a substrate having low heat resistance by light irradiation, having unlimited sintering conditions, excellent adhesion to a resin substrate, and capable of forming an electroconductive film having good electroconductivity.

As a result of diligent research, the present inventors found that an electroconductive film having excellent sinterability, adhesion, and electroconductivity can be produced using an electroconductive paste containing specific fine copper particles without using an azole compound that causes a decrease in adhesion when made into an electroconductive film, and the present invention has been completed.

### MEANS FOR SOLVING THE PROBLEM

The present invention provides the following electroconductive paste, a substrate equipped with an electroconductive film, and a method for manufacturing a substrate equipped with an electroconductive film.
[1] An electroconductive paste wherein the electroconductive paste containing fine copper particles having an average particle diameter of 300 nm or less which is measured using SEM, coarse copper particles having an average particle diameter of 3 ∼ 11 µm which is measured using SEM, a binder resin, and a dispersion medium, wherein the fine copper particles includes a coating film containing cuprous oxide and copper carbonate on at least a part of the surface thereof,
   the ratio of the mass oxygen concentration to the specific surface area of the fine copper particles is 0.1 ∼ 1.2 % by mass·g/m²,
   the ratio of the mass carbon concentration to the specific surface area of the fine copper particles is controlled to 0.008 ∼ 0.3 % by mass·g/m², and
   the amount of the binder resin is 2.5 ∼ 6 parts by mass with respect to the total of 100 parts by mass of the fine copper particles and the coarse copper particles.
[2] The electroconductive paste according to [1], wherein the coarse copper particles are flat copper particles in the form of flakes, and the tap density of the coarse copper particles is 2 ∼ 6 g/cm³.
[3] The electroconductive paste according to [1] or [2], wherein the binder resin is polyvinylpyrrolidone.
[4] The electroconductive paste according to any one of [1] to [3], wherein the dispersion medium is ethylene glycol.
[5] A substrate equipped with an electroconductive film including a sintered product of the electroconductive paste according to any one of [1] to [4], and a substrate on which the sintered product is provided.
[6] A method for manufacturing a substrate equipped with an electroconductive film, including a step in which a film containing an electroconductive paste according to any one of [1] to [4] is formed on a substrate, and a step in which the film is heat-treated.

### EFFECTS OF THE INVENTION

According to the electroconductive paste of the present invention, an electroconductive film having excellent adhesion to a resin substrate and having good electroconductivity can be formed on a substrate having low heat resistance by irradiation with light without limitations of sintering conditions.

### BRIEF DESCRIPTION OF DRAWINGS

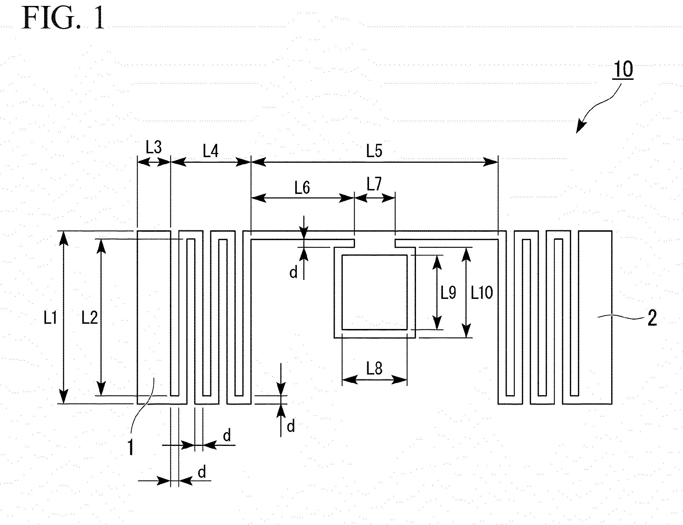

FIG. 1 is a schematic diagram showing a wiring pattern of an electroconductive film for evaluation used in Examples.

### DETAILED DESCRIPTION OF THE PREFERRED EMBODIMENTS

In the present description, "∼" indicating a numerical range means that the numerical values before and after are included as the lower limit value and the upper limit value, respectively.

### <Electroconductive paste>

The electroconductive paste of the present invention contains fine copper particles having an average particle diameter of 300 nm or less, coarse copper particles having an average particle diameter of 3 ∼ 11 µm, a binder resin, and a dispersion medium as essential components. The electroconductive paste of the present invention may further contain arbitrary components other than these essential components as long as the effects of the present invention are not impaired.

### (Fine copper particles)

The average particle diameter of the fine copper particles is 300 nm or less, and preferably 200 nm or less. When the average particle diameter of the fine copper particles is 300 nm or less, the fine copper particles can be easily sintered, and the sintering temperature of the electroconductive paste is lowered.

The lower limit of the average particle diameter of the fine copper particles is preferably 50 nm or more, and more preferably 100 nm or more. When the lower limit value of the average particle diameter of the fine copper particles is 50 nm, and preferably 100 nm, the amount of gas generated during the sintering of the electroconductive paste is relatively small, and cracks can be further reduced when the electrolytic film is formed. As a result, the adhesion with the resin substrate is further improved when the electroconductive film is formed.

As explained above, the average particle diameter of the fine copper particles is preferably 50 ∼ 300 nm, and more preferably 100 ∼ 200 nm.

The average particle diameter of the fine copper particles can be measured using a scanning electron microscope (SEM). For example, the particle diameter of a plurality of fine copper particles may be measured in an electron microscope image, and the average value thereof may be calculated to obtain the average particle diameter of the fine copper particles.

The fine copper particles have a coating film containing cuprous oxide and copper carbonate on at least a part of the surface thereof. In particular, since the coating film of the fine copper particles contains copper carbonate, the sintering temperature of the fine copper particles is lower than that of the conventional product. Here, the presence of an excess amount of copper carbonate can be an inhibitory factor for sintering. Therefore, it is considered that the lower the amount of copper carbonate in the coating film, the lower the sintering temperature.

From the above, the ratio of the mass carbon concentration to the specific surface area of the fine copper particles is 0.008 ∼ 0.3 % by mass ∼ g/m², and preferably 0.008 ∼ 0.020 % by mass·g/m². When the ratio of the mass carbon concentration to the specific surface area of the fine copper particles is 0.008 ∼ 0.3 % by mass·g/m², the sintering temperature of the copper particles is lowered, and the fine copper particles can be sintered at a lower temperature.

The ratio of the mass carbon concentration to the specific surface area of the fine copper particles can be measured using a carbon sulfur analyzer (for example, "EMIA-920V" manufactured by Horiba Seisakusho Co., Ltd.).

The ratio of the mass oxygen concentration to the specific surface area of the fine copper particles is 0.1 ∼ 1.2 % by mass·g/m², and preferably 0.2 ∼ 0.5 % by mass·g/m². When the ratio of the mass oxygen concentration to the specific surface area of the fine copper particles is 0.1% by mass·g/m² or more, the chemical stability of the fine copper particles becomes sufficient, and phenomena such as combustion and heat generation of the fine copper particles are unlikely to occur.

When the ratio of the mass oxygen concentration to the specific surface area of the fine copper particles is 1.2 % by mass·g/m² or less, the amount of copper oxide is small, the fine copper particles can be easily sintered, and the sintering temperature of the electroconductive paste is reduced. Here, since the surface of the fine copper particles is oxidized by the air in the atmosphere and an oxide coating film is inevitably formed, the lower limit of the ratio of the mass oxygen concentration to the specific surface area of the fine copper particles is 0.1 % by mass·g/m².

The ratio of the mass oxygen concentration to the specific surface area of the fine copper particles can be measured using an oxygen nitrogen analyzer (for example, "TC600" manufactured by LECO).

The fine copper particles can be produced, for example, by the production method disclosed in Japanese Unexamined Patent Application, First Publication No. 2018-127657. Specifically, the ratio of the mass carbon concentration to the specific surface area of the fine copper particles is controlled to 0.008 ∼ 0.3 % by mass·g/m² by adjusting the carbon amount of a fuel gas supplied into a burner.

### (Coarse copper particles)

The coarse copper particles are copper particles having an average particle diameter of 3 ∼ 11 µm. The average particle diameter of the coarse copper particles is preferably 3 ∼ 7 µm.

Since the average particle diameter of the coarse copper particles is 3 µm or more, the shrinkage of the fine copper particles during sintering is reduced, and cracks are less likely to occur when the electroconductive film is formed. When the average particle diameter of the coarse copper particles is 11 µm or less, the electroconductive paste can be sufficiently sintered while maintaining the effect of reducing the shrinkage of the fine copper particles, and the electroconductivity of the electroconductive film is improved.

The average particle diameter of the coarse copper particles can be measured using a scanning electron microscope (SEM). For example, the particle diameters of a plurality of coarse copper particles in an electron microscope image may be measured, and the average value thereof may be calculated to obtain the average particle diameter of the coarse copper particles.

The coarse copper particles are preferably flattened into flakes. When coarse copper particles flattened into flakes are used, the density of the film after the electroconductive paste is coated on the substrate and dried is lowered, and gas generated during sintering is easily released. Therefore, cracks are less likely to occur when the electroconductive film is formed.

The tap density of the coarse copper particles is preferably 2 ∼ 6 g/cm³, and more preferably 2 ∼ 4 g/cm³.

When the tap density of the coarse copper particles is 2 g/cm³ or more, the electroconductive paste can be more sufficiently sintered while maintaining the effect of reducing the shrinkage of the fine copper particles, and the electroconductivity of the electroconductive film is further improved. When the tap density of the coarse copper particles is 6 g/cm³ or less, the density of the electroconductive film after the electroconductive paste is coated on the substrate and dried is lowered, and gas generated during sintering is easily released. Therefore, cracks are less likely to occur when the electroconductive film is formed.

The tap density (g/cm³) of the coarse copper particles can be measured using a tap density meter (for example, "KYT-4000" manufactured by Seishin Enterprise Co., Ltd.).

### (Dispersion medium)

The dispersion medium is not particularly limited as long as it is a compound in which the fine copper particles and the coarse copper particles can be dispersed. Specific examples of the dispersion medium include water; alcohols such as methanol, ethanol, 1-propanol, 2-propanol (IPA) and terpineol; polyols such as ethylene glycol, diethylene glycol and triethylene glycol; and polar media such as N, N-dimethylformamide (DMF), and N-methylpyrrolidone (NMP). These dispersion media may be used alone or in combination of two or more.

Among these, ethylene glycol is preferable as the dispersion medium because it has a reducing effect on fine copper particles.

### (Binder resin)

The binder resin imparts an appropriate viscosity to the electroconductive paste, and imparts adhesion to the substrate when it is made into an electroconductive film.

Specific examples of the binder resin include cellulose derivatives such as carboxyl cellulose, ethyl cellulose, cellulose ether, carboxyl ethyl cellulose, amino ethyl cellulose, oxyethyl cellulose, hydroxymethyl cellulose, hydroxyethyl cellulose, hydroxypropyl cellulose, methyl cellulose, benzyl cellulose and trimethyl cellulose; acrylic polymer, for example, copolymers of acrylic monomer such as methyl (meta)acrylate, ethyl (meth)acrylate, butyl (meth)acrylate, benzyl (meth)acrylate, hydroxyethyl (meth)acrylate, dimethyl aminoethyl acrylate, acrylic acid, and methacrylic acid; and nonionic surfactants such as polyvinyl alcohol and polyvinyl pyrrolidone. However, the binder resin is not limited to these examples.

Among these, polyvinylpyrrolidone is preferable as the binder resin from the viewpoint of improving the dispersibility of the fine copper particles. Polyvinylpyrrolidone further has a function as a dispersant described later in addition to the function as a binder resin as described above. Therefore, by using polyvinylpyrrolidone as a binder resin, the dispersibility of fine copper particles is improved, and it is not necessary to use a dispersant in combination. As a result, the number of components of the electroconductive paste can be reduced. Therefore, the number of constituent components that can affect the two characteristics of i) the sinterability of fine copper particles and ii) the adhesion to the resin substrate when used as an electroconductive film is reduced, and the effect of the present invention can be obtained more remarkably.

### (Optional component)

Examples of the optional component include a dispersant.

Examples of the dispersant include sodium hexametaphosphate, sodium naphthalene sulfonate formaldehyde condensate, and the like. These dispersants may be used alone or in combination of two or more.

As the dispersant, a compound that can be decomposed and removed at the time of sintering is preferable.

The viscosity of the electroconductive paste of the present invention is preferably 30,000 ∼ 200,000 mPa·s, and more preferably 60,000 ∼ 120,000 mPa·s. When the viscosity of the electroconductive paste is the lower limit or more, the electroconductive paste has an appropriate viscosity, and the electroconductive paste has excellent handleability. When the viscosity of the electroconductive paste is the upper limit or less, the electroconductive paste has excellent stability during storage.

The viscosity of the electroconductive paste is a value measured by a viscometer ("TVE-35H" manufactured by Toki Sangyo Co., Ltd.) under the conditions of 25°C and a rotation speed of 5.9 rpm.

The amount of the fine copper particles is preferably 30 ∼ 85% by mass with respect to the total of 100% by mass of the fine copper particles and the coarse copper particles.

When the amount of the fine copper particles is 30% by mass or more with respect to the total of 100% by mass of the fine copper particles and the coarse copper particles, the electroconductive paste can be sufficiently sintered, and the electroconductivity of the electroconductive film is further improved.

When the amount of the fine copper particles is 85% by mass or less with respect to the total of 100% by mass of the fine copper particles and the coarse copper particles, the shrinkage of the fine copper particles during sintering is further reduced, and when the electroconductive film is formed, cracks are less likely to occur.

The amount of the coarse copper particles is preferably 15 ∼ 70% by mass, and more preferably 50 ∼ 70% by mass with respect to the total of 100% by mass of the fine copper particles and the coarse copper particles.

When the amount of the coarse copper particles is 15% by mass or more with respect to the total of 100% by mass of the fine copper particles and the coarse copper particles, the shrinkage of the fine copper particles during sintering is further reduced, and when the electroconductive film is formed, cracks are less likely to occur.

When the amount of the coarse copper particles is 70% by mass or less with respect to the total of 100% by mass of the fine copper particles and the coarse copper particles, the electroconductive paste can be sufficiently sintered while maintaining the effect of reducing the shrinkage of the fine copper particles, and the electroconductivity of the electroconductive film becomes even better.

The amount of the binder resin is 2.5 ∼ 6 parts by mass, and more preferably 3 ∼ 4 parts by mass with respect to the total of 100 parts by mass of the fine copper particles and the coarse copper particles.

When the amount of the binder resin is 2.5 parts by mass or more with respect to the total of 100 parts by mass of the fine copper particles and the coarse copper particles, the electroconductivity of the electroconductive film is improved.

When the amount of the binder resin is 6 parts by mass or less with respect to the total of 100 parts by mass of the fine copper particles and the coarse copper particles, the amount of gas derived from the binder resin generated during sintering is reduced and cracks are less likely to occur in the electroconductive film. The electroconductivity of the electroconductive film is improved.

When the electroconductive paste further contains the dispersant, the amount of the dispersant is preferably 0.5 ∼ 2.5 parts by mass, and more preferably 1 ∼ 2 parts by mass with respect to the total of 100 parts by mass of the fine copper particles and the coarse copper particles.

### (Production method)

The electroconductive paste of the present invention can be produced, for example, by a production method including the following steps 1 and 2.
Step 1: A step in which the fine copper particles, the coarse copper particles, the binder resin, the dispersion medium, and the dispersant if necessary are pre-kneaded.
Step 2: A step in which the pre-kneaded paste obtained in step 1 is dispersed using a disperser such as a 3-roll mill.

In the pre-kneading in step 1, a kneader such as a self-revolving mixer, a mixer, and a mortar can be used. Pre-kneading may be performed while degassing.

In step 2, if it is difficult to disperse the fine copper particles in the dispersion medium by one dispersion treatment, the dispersion treatment may be performed a plurality of times.

### (Effects)

In the electroconductive paste of the present invention described above, the average particle diameter of the fine copper particles is 300 nm or less, and the fine copper particles have a coating film containing cuprous oxide and copper carbonate on at least a part of the surface thereof, and the ratio of the mass carbon concentration to the specific surface area of the fine copper particles is 0.3 % by mass·g/m² or less. Therefore, the sinterability of the fine copper particles is improved, the sintering temperature of the fine copper particles is lowered, and an electroconductive film can be formed by light irradiation on a substrate having low heat resistance.

Since the electroconductive paste of the present invention contains the fine copper particles having excellent sinterability, it is not necessary to use an azole compound for the purpose of improving light absorption during sintering by light irradiation. Therefore, the amount of gas generated when the electroconductive paste is sintered is reduced, cracks are less likely to occur in the sintered film, and the adhesion with the substrate is improved when the electroconductive film is formed. Further, since it is not necessary to irradiate light having a specific wavelength, the production conditions for photo-sintering are not limited, which is preferable in industrial production. Further, according to the electroconductive paste of the present invention, it is possible to avoid denaturation of the copper particles by the azole compound, and the stability of the electroconductive paste is less likely to be impaired.

The electroconductive paste of the present invention contains the coarse copper particles having an average particle diameter of 3 ∼ 11 µm, and the amount of the binder resin is 6 parts by mass or less with respect to the total of 100 parts by mass of the fine copper particles and the coarse copper particles. Therefore, the shrinkage of the fine copper particles during sintering can be reduced, and the amount of gas derived from the binder resin generated during sintering is reduced. As a result, cracks are less likely to occur in the electroconductive film during sintering, and an electroconductive film having excellent electroconductivity can be formed.

As described above, the electroconductive paste of the present invention contains the fine copper particles having a low sintering temperature and has excellent sinterability. Therefore, it is not necessary to add a sintering accelerator to the paste paint dissimilar to Examples of Patent Document 4, and there is no possibility that chlorine remains when the film is made into an electroconductive film. As a result, when the formed electroconductive film is used in an electronic component, defects due to residual chlorine are less likely to occur.

Further, according to the electroconductive paste of the present invention, since the sintering temperature of the fine copper particles is low, an electroconductive film can be formed on the substrate at a lower temperature than the conventional product. Therefore, the thermal load applied to the substrate during sintering is less than that of the conventional product, and the durability of a substrate equipped with the electroconductive film described later is improved.

### <Substrate equipped with an electroconductive film>

The substrate equipped with an electroconductive film of the present invention includes the sintered product of the electroconductive paste of the present invention and a substrate on which the sintered product is provided. The sintered product of the electroconductive paste contains at least one selected from the group consisting of a fusion product of the fine copper particles, a fusion product of the coarse copper particles, and a fusion product of the fine copper particles and the coarse copper particles. The binder resin and the dispersion medium are vaporized, decomposed, and removed at the time of sintering, and are usually not contained in the sintered product. However, a residue derived from the binder resin and the dispersion medium may be contained as long as the effect of the present invention is not impaired.

The substrate is not particularly limited as long as it can be provided with a sintered electroconductive paste. For example, a glass substrate; a resin substrate containing a resin such as polyamide, polyimide, polyethylene, epoxy resin, phenol resin, polyester resin, and polyethylene terephthalate (PET); a paper substrate; and the like can be used.

Among these, since the effect of the present invention is particularly remarkable, a resin substrate is preferable as the substrate, and a polyethylene terephthalate substrate containing polyethylene terephthalate is more preferable.

The substrate equipped with an electroconductive film of the present invention can be produced, for example, by coating the electroconductive paste to the substrate to produce a film containing the electroconductive paste on the substrate, and then heat-treating the film containing the electroconductive paste.

The method of coating the electroconductive paste to the substrate is not particularly limited. For example, printing methods such as screen printing, inkjet printing, and gravure printing can be used. The coating method of the electroconductive paste is not limited to these examples.

The heat treatment is not particularly limited as long as the fine copper particles in the electroconductive paste can be sintered. For example, a method of sintering the substrate equipped with the film containing an electroconductive paste at a high temperature; a method of sintering the film containing the electroconductive paste with a light beam such as a laser; and photolithography can be mentioned. Specific embodiments of the heat treatment are not limited to these examples. By carrying out the heat treatment, the fine copper particles are sintered with each other, and the electroconductive film having electroconductivity is produced on the substrate.

The electroconductive film, which is a sintered product provided on the substrate, has electroconductivity. The volume resistance value and film thickness of the electroconductive film can be appropriately changed according to the application of the substrate equipped with an electroconductive film.

The volume resistance value of the electroconductive film is, for example, preferably less than 1.0 × 10⁻⁴ Ω·cm, and more preferably less than 5.0 × 10⁻⁵ Ω·cm. The film thickness of the electroconductive film is, for example, preferably 5 ∼ 30 µm, and more preferably 10 ∼ 25 µm.

As described above, since the substrate equipped with an electroconductive film of the present invention includes the sintered product of the electroconductive paste of the present invention, it includes an electroconductive film having excellent adhesion between the substrate and the electroconductive film.

The substrate equipped with an electroconductive film of the present invention can be used in, for example, printed wiring boards, wireless substrates such as Rf tags, pressure-sensitive sensor sheets, transparent electroconductive films, and the like.

### <Examples>

Hereinafter, the present invention will be specifically described with reference to Examples, but the present invention is not limited to the following description.

### [Material]

### (Fine copper particles A to C)

Fine copper particles A to C were produced under the production conditions shown in Table 1 according to the method described in Examples of Japanese Unexamined Patent Application, First Publication No. 2018-127657. Here, in Table 1, "methane + hydrogen" means a mixed gas containing 95% of hydrogen gas and 5% of methane gas.

For the obtained fine copper particles A to C, the average particle diameter, the ratio of the mass oxygen concentration and the mass carbon concentration to the specific surface area of the fine copper particles were measured. The measurement results are shown in Table 1.

**[Table 1]**

| | Fine copper particles A | Fine copper particles B | Fine copper particles C | Fine copper particles D | Fine copper particles E |
|---|---|---|---|---|---|
| Fuel gas | propane | methane | methane + hydrogen | propane | methane |
| Carbon element concentration in fuel gas [atom%] | 27.23 | 20 | 2.33 | 27.23 | 20 |
| Cooling gas | air | air | air | air | air |
| Oxygen ratio of combustion-supporting gas supplied into burner | 0.9 | 0.9 | 0.5 | 0.4 | 0.98 |
| Average particle diameter of fine copper particles [nm] | 110 | 58 | 209 | 152 | 155 |
| Mass oxygen concentration to specific surface area of fine copper particles [% by mass·g/m²] | 0.25 | 0.4 | 0.36 | 0.20 | 1.1 |
| Mass carbon concentration to specific surface area of fine copper particles [% by mass·g/m²] | 0.03 | 0.019 | 0.03 | 0.24 | 0.021 |

### (Fine copper particles F)

Fine copper particles F of which the surface was coated with benzotriazole were produced according to the method described in Japanese Unexamined Patent Application, First Publication No. 2017-66269, paragraph 0039. The average particle diameter of the fine copper particles F was 50 nm.

### (Coarse copper particles A to E)

Coarse copper particles A: "MA-C03KP" manufactured by Mitsui Mining & Smelting Co., Ltd. (average particle diameter 3.8 µm, tap density 5.26 g/cm³)
Coarse copper particles B: "FCC-115" manufactured by Fukuda Metal Foil Powder Industry Co., Ltd. crushed with a ball mill (average particle diameter 10.2 µm, tap density 2.6 g/cm³)
Coarse copper particles C: "FCC-TB" manufactured by Fukuda Metal Foil Powder Industry Co., Ltd. (average particle diameter 6.22 µm, tap density 2.57 g/cm³)
Coarse copper particles D: "MA-C025KFD" manufactured by Mitsui Mining & Smelting Co., Ltd. (average particle diameter 6.14 µm, tap density 4 g/cm³)
Coarse copper particles E: "FCC-115" manufactured by Fukuda Metal Foil Powder Industry Co., Ltd. pulverized with a vibration mill according to the method described in Japanese Unexamined Patent Application, First Publication No. 2017-66269, paragraph 0040 (average particle diameter 5.7 µm, tap density 3.6 g/cm³)

### [Measuring method]

### (Average particle diameter of fine copper particles)

The average particle diameter of the fine copper particles was measured using a scanning electron microscope (SEM) ("JSM-6700F" manufactured by JEOL Ltd.). Specifically, the particle diameter of the fine copper particles was measured for 20 fields of view at a magnification of 20,000 times, and the average value of 20 fields of view was calculated.

### (Average particle diameter of coarse copper particles)

The average particle diameter of the coarse copper particles was measured using a scanning electron microscope (SEM) ("JSM-6700F" manufactured by JEOL Ltd.). Specifically, the particle diameter of the coarse copper particles was measured for 20 fields of view at a magnification of 2,000, and the average value of 20 fields of view was calculated.

### (Ratio of mass oxygen concentration)

The ratio of the mass oxygen concentration to the specific surface area of the fine copper particles was measured using an oxygen nitrogen analyzer ("TC600" manufactured by LECO).

### (Ratio of mass carbon concentration)

The ratio of the mass carbon concentration to the specific surface area of the fine copper particles was measured using a carbon sulfur analyzer ("EMIA-920V" manufactured by Horiba Seisakusho Co., Ltd.).

### (Tap density)

The tap density of the coarse copper particles was measured using a tap density meter ("KYT-4000" manufactured by Seishin Enterprise Co., Ltd.).

### [Evaluation method]

### (Adhesion)

A bending test (based on JIS K5600-5-1) was performed using test substrates of each Example and Comparative Example described later. Specifically, the test substrate was wound around a ϕ25 mm mandrel, a PET film was bent 180°, and then the bending was released to return the PET film to its original position. The adhesion of the test substrate after the bending test was judged according to the following evaluation criteria.
Good: Sintered electroconductive film was not peeled off from the PET film, and no cracks were visually observed.
Poor: Sintered electroconductive film was peeled off from the PET film and floats, or cracks were visually confirmed.

### (Electroconductivity)

The wiring resistance of the test substrate equipped with the wiring pattern 10 shown in FIG. 1 in each Example and Comparative Example was measured by applying a test lead of a digital multimeter ("CDM-09N" manufactured by Custom Co., Ltd.) to each of a first end portion 1 and a second end portion 2, and electroconductivity was judged according to the following evaluation criteria.
Good: Wiring resistance was less than 10 Ω
Poor: Wiring resistance was 10 Ω or more

The wiring pattern 10 has the first end portion 1 and the second end portion 2. In FIG. 1, d indicates the width of the line in the electroconductive film. L1 to L10 indicate the dimensions of each part of the wiring pattern 10.

The dimensional values of d and L1 to L10 in the wiring pattern 10 used for the electroconductivity evaluation are shown below.

| | |
|---|---|
| D: | 1 mm |
| L1: | 21 mm |
| L2: | 19 mm |
| L3: | 4 mm |
| L4: | 10 mm |
| L5: | 30 mm |
| L6: | 12.5 mm |
| L7: | 5 mm |
| L8: | 8 mm |
| L9: | 9 mm |
| L10: | 11 mm |

The line length of the wiring pattern 10 used for the evaluation of electroconductivity is 250 mm, and each dimension is shown above. Here, the line length of the wiring pattern 10 means the length of the shortest path of the wiring circuit formed by the electroconductive film existing between the first end portion 1 and the second end portion 2. By using the test substrate equipped with the wiring pattern 10 shown in FIG. 1, the resistance between the line lengths of 250 mm can be measured.

### [Example 1]

The fine copper particles A: 2.4 g, the coarse copper particles A: 5.6 g, polyvinylpyrrolidone ("K-85N" manufactured by Nippon Catalyst Co., Ltd.): 0.2 g, ethylene glycol: 1.66 g, and sodium naphthalene sulfonate formaldehyde condensate ("Demor N" manufactured by Kao Chemical Co., Ltd.): 0.14 g were pre-kneaded using a kneader ("AR-100" manufactured by Shinky Co., Ltd.) to obtain a pre-kneaded paste. The obtained pre-kneaded paste was subjected to a dispersion treatment using a 3-roll disperser ("BR-100V" manufactured by Imex Co., Ltd.) to produce an electroconductive paste.

Next, the obtained electroconductive paste was coated on a PET film (thickness: 125 µm, "A4300" manufactured by Toyobo Co., Ltd.) with a film thickness of 30 µm by screen printing so as to form the wiring pattern 10 shown in FIG. 1. Then, photocuring was performed using a photo-sintering device ("Pulse Forge ® 1200" manufactured by Novacentrix), and the electroconductive paste was sintered to obtain a PET film equipped with an electroconductive film constituting the wiring pattern 10 shown in FIG. 1. The PET film with the electroconductive film thus obtained was used as the test substrate of Example 1.

### [Examples 2 to 13, and Comparative Examples 1 and 2]

The electroconductive paste of each Example and Comparative Example was produced in the same manner as in Example 1 except that the fine copper particles and the coarse copper particles used were changed, and the ratio of the amounts of the fine copper particles and the coarse copper particles (amount of the fine copper particles: amount of the coarse copper particles) and the amount of the binder resin were changed as shown in Tables 2 and 3. A PET film equipped with an electroconductive film was produced using the electroconductive paste obtained in each Example and Comparative Example, and used as a test substrate for each Example and Comparative Example.

### [Comparative Example 3]

An electroconductive paste was produced in the same manner as in Example 1 except that the fine copper particles D, the coarse copper particles E, copper oxide, polyvinylpyrrolidone, and ethylene glycol were pre-kneaded to obtain a pre-kneaded paste. A PET film equipped with an electroconductive film was produced using the obtained electroconductive paste and used as a test substrate.

Adhesion and electroconductivity were evaluated according to the evaluation method above using the test substrate obtained in each Example and Comparative Example. The results are shown in Tables 2 and 3. In Tables 2 and 3, "E" means a power of 10. For example, "6.9E-05" is "6.9 × 10⁻⁵".

**[Table 2]**

| | Example 1 | Example 2 | Example 3 | Example 4 | Example 5 | Example 6 | Example 7 |
|---|---|---|---|---|---|---|---|
| Fine copper particles used | Fine copper particles A | Fine copper particles A | Fine copper particles A | Fine copper particles A | Fine copper particles A | Fine copper particles A | Fine copper particles B |
| Coarse copper particles used | Coarse copper particles A | Coarse copper particles A | Coarse copper particles A | Coarse copper particles A | Coarse copper particles A | Coarse copper particles A | Coarse copper particles A |
| Ratio of amount of fine copper particles and coarse copper particles with respect to 100% by mass of conductive paste [% by mass] | 80 | 80 | 80 | 80 | 80 | 80 | 80 |
| Amount of fine copper particles : Amount of coarse copper particles | 3 : 7 | 3 : 7 | 3 : 7 | 5 : 5 | 8.5 : 1.5 | 8.5 : 1.5 | 3 : 7 |
| Amount of binder with respect to total of 100% by mass of fine copper particles and course copper particles [% by mass] | 2.5 | 3 | 3.5 | 4 | 5.5 | 6 | 3.5 |
| Viscosity [mPa·s] | 185,600 | 135,300 | 112,400 | 196,200 | 77,000 | 54,500 | 164,200 |
| Wiring resistance [Ω] | 8.2 | 5.1 | 7.9 | 8.4 | 8.1 | 9.8 | 5.3 |
| Film thickness after sintering [µm] | 21 | 19.8 | 20.8 | 23 | 19.4 | 21 | 18.7 |
| Volume resistance of conductive film [Ω·cm] | 6.9 E-05 | 4.0 E-05 | 6.6 E-05 | 7.7 E-05 | 6.3 E-05 | 8.2 E-05 | 4.0 E-05 |
| Conductivity | Good | Good | Good | Good | Good | Good | Good |
| Adhesion | Good | Good | Good | Good | Good | Good | Good |

**[Table 3]**

| | Example 8 | Example 9 | Example 10 | Example 11 | Example 12 | Example 13 | Com. Example 1 | Com. Example 2 | Com. Example 3 |
|---|---|---|---|---|---|---|---|---|---|
| Fine copper particles used | Fine copper particles C | Fine copper particles A | Fine copper particles A | Fine copper particles A | Fine copper particles D | Fine copper particles E | Fine copper particles A | Fine copper particles A | Fine copper particles F |
| Coarse copper particles used | Coarse copper particles A | Coarse copper particles B | Coarse copper particles C | Coarse copper particles D | Coarse copper particles A | Coarse copper particles A | Coarse copper particles A | Coarse copper particles A | Coarse copper particles E |
| Ratio of amount of fine copper particles and coarse copper particles with respect to 100% by mass of conductive paste [% by mass] | 80 | 80 | 80 | 80 | 80 | 80 | 80 | 80 | 80 |
| Amount of fine copper particles : Amount of coarse copper particles | 3 : 7 | 3:7 | 3 : 7 | 3 : 7 | 3:7 | 3 : 7 | 3:7 | 3:7 | 6:4 |
| Amount of binder with respect to total of 100% by mass of fine copper particles and course copper particles [% by mass] | 2.5 | 3 | 3 | 3 | 2.5 | 2.5 | 2 | 6.5 | 5.5 |
| Viscosity [mPa·s] | 89,700 | 99,400 | 117,000 | 84,200 | 192,200 | 182,400 | 294,400 | 43,000 | 150,000 |
| Wiring resistance [Ω] | 8.9 | 3.1 | 3.1 | 3.7 | 9.4 | 6.9 | 20.2 | 298 | 15.4 |
| Film thickness after sintering [µm] | 23.4 | 23 | 20.1 | 20.4 | 22.8 | 19.1 | 21.4 | 20.9 | 20.1 |
| Volume resistance of conductive film [Ω·cm] | 8.3 E-05 | 2.9 E-05 | 2.5 E-05 | 3.0 E-05 | 8.6 E-05 | 5.3 E-05 | 1.7 E-04 | 2.5 E-03 | 1.2 E-04 |
| Conductivity | Good | Good | Good | Good | Good | Good | Poor | Poor | Poor |
| Adhesion | Good | Good | Good | Good | Good | Good | Good | Good | Poor |

In Examples 1 to 13, the conductive paste having the ratio of the mass oxygen concentration to the specific surface area of the fine copper particles, the ratio of the mass carbon concentration to the specific surface area of the fine copper particles, and the amount of the binder resin within the ranges specified in the present invention was formed on the PET film. The electroconductive films obtained in Examples 1 to 13 had both excellent adhesion to the substrate and electroconductivity.

In Comparative Examples 1 and 2, the amount of the binder resin was outside the range specified in the present invention. In this case, the electroconductivity of the obtained electroconductive film was not sufficient.

In Comparative Example 3, the fine copper particles of which the surface was coated with benzotriazole were used, and the ratio of the mass oxygen concentration and the ratio of the mass carbon concentration to the specific surface area of the fine copper particles were outside the range specified in the present invention. In this case, neither the adhesion of the obtained electroconductive film to the substrate nor the electroconductivity was sufficient.

From the results of the Examples and Comparative Examples, it was confirmed that an electroconductive film could be formed on a PET film having low heat resistance by light irradiation, and that an electroconductive paste which could produce an electroconductive film having excellent adhesion to the PET film and good electroconductivity could be formed.

### EXPLANATION OF REFERENCE NUMERALS

- 1: first end portion
- 2: second end portion
- 10: wiring pattern
- d: line width of the electroconductive film
- L1 ∼ L10: dimensions of each part of wiring pattern

## Claims

1. An electroconductive paste
wherein the electroconductive paste contains:
fine copper particles having an average particle diameter of 300 nm or less which is measured using SEM;
coarse copper particles having an average particle diameter of 3 ∼ 11 µm which is measured using SEM;
a binder resin; and
a dispersion medium,
the fine copper particles include a coating film containing cuprous oxide and copper carbonate on at least a part of the surface thereof,
the ratio of the mass oxygen concentration to the specific surface area of the fine copper particles is 0.1 ∼ 1.2 % by mass·g/m²,
the ratio of the mass carbon concentration to the specific surface area of the fine copper particles is controlled to 0.008 ∼ 0.3 % by mass·g/m², and
the amount of the binder resin is 2.5 ∼ 6 parts by mass with respect to the total of 100 parts by mass of the fine copper particles and the coarse copper particles.

2. The electroconductive paste according to Claim 1, wherein the coarse copper particles are flat copper particles in the form of flakes, and the tap density of the coarse copper particles is 2 ∼ 6 g/cm³.

3. The electroconductive paste according to Claim 1 or 2, wherein the binder resin is polyvinylpyrrolidone.

4. The electroconductive paste according to any one of Claims 1 to 3, wherein the dispersion medium is ethylene glycol.

5. A substrate equipped with an electroconductive film including a sintered product of the electroconductive paste according to any one of Claims 1 to 4, and a substrate on which the sintered product is provided.

6. A method for manufacturing a substrate equipped with an electroconductive film, including a step in which a film containing an electroconductive paste according to any one of Claims 1 to 4 is formed on a substrate, and a step in which the film is heat-treated.
